(19) Europäisches Patentamt
European Patent Office
Office européen des brevets

(11) Publication number: **0 117 980**
**B1**

(12) **EUROPEAN PATENT SPECIFICATION**

(45) Date of publication of patent specification: **06.05.87**

(51) Int. Cl.[4]: **H 01 L 21/316**, H 01 L 31/02, H 01 L 31/18

(21) Application number: **84100494.8**

(22) Date of filing: **18.01.84**

(54) **Process for forming passivation film on photoelectric conversion device and the device produced thereby.**

(30) Priority: **02.02.83 JP 15832/83**

(43) Date of publication of application: **12.09.84 Bulletin 84/37**

(45) Publication of the grant of the patent: **06.05.87 Bulletin 87/19**

(84) Designated Contracting States: **DE NL**

(56) References cited:
**EP-A-0 030 798**
**EP-A-0 040 076**
**EP-A-0 046 059**
**US-A-4 379 943**

**JOURNAL OF ELECTROCHEMICAL SOCIETY, vol. 128, no. 7, July 1981, Manchester A.C. ADAMS et al. "Characterization of plasma-deposited silicon dioxide", pages 1545-1551**

(73) Proprietor: **FUJI XEROX CO., LTD.**
**No. 3-5, Akasaka 3-chome**
**Minato-ku Tokyo 107 (JP)**

(72) Inventor: **Fuse, Mario c/o Fuji Xerox Co., Ltd.**
**Ebina Works 2274 Hongo**
**Ebina-shi Kanagawa-ken (JP)**

(74) Representative: **von Kreisler, Alek, Dipl.-Chem. et al**
**Deichmannhaus am Hauptbahnhof**
**D-5000 Köln 1 (DE)**

**EP 0 117 980 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

Background of the invention

1. Field of the invention

This invention relates to a process for producing a photoelectric conversion device and to the photoelectric conversion device produced thereby. Particularly, the present invention relates to a process for forming a passivation film made of silicon oxide on a photoelectric conversion device having junction between hydrogenated amorphous silicon and ITO (indium-tin oxide).

2. Description of the prior art

A photoelectric conversion device has been utilized as an image sensor for reading an original in a facsimile equipment and the like.

Fig. 1 is a sectional view showing a conventional image sensor 1 constructed by the steps of forming a lower electrode 3 on an insulating substrate 2 so as to cover a part of the lower electrode 3, and providing a transparent upper electrode 5 on the hydrogenated amorphous silicon film 4.

Material for the insulating substrate 2 may be ceramics, glass or plastics. Such insulating substrate must be of high mechanical strength and of high heat resistance so as not to be softened by heat which is applied to the substrate during manufacturing of the image sensor 1. In addition, high insulating properties are also required.

The lower electrode 3 is made of metal such as chromium (Cr), nickel (Ni), platinum (Pt), palladium (Pd), titanium (Ti), molybdenum (Mo), tantalum (Ta), and is prepared, for example, by coating the above metal in the form of a film having a thickness of 50 nm (500 Å) to 500 nm (5000 Å) onto the substrate 2. The coated metal is then subjected to photolithography and etching so as to be a suitable size and shape. As the hydrogenated amorphous silicon film 4, a non-dope type silicon film, a p-type silicon film doped with an element such as boron (B) and the like belonging to group III of the periodic table, or the like silicon film is employed. As a process for forming the amorphous silicon film 4, for example, plasma CVD method has been adopted to deposit the film having a thickness of around 1 µm.

For the transparent upper electrode 5, an ITO film is employed and the transparent upper electrode 5 is formed with a thickness of around 50 nm (500 Å) to 200 nm (2000 Å) in accordance with, for instance, reactive deposition process, reactive sputtering process or the like process.

The image sensor 1 having the above-mentioned laminated construction possesses excellent characteristic properties. For example, a ratio between light current and dark current (light/dark current ratio) is $10^3$ or more and response time to light pulse is 1 ms or less.

In this connection, the dark current is suppressed by means of an electron barrier layer (not shown) formed at the boundary of the amorphous silicon film 4 and the transparent upper electrode 5, and such electron barrier layer is one of the factors determining the light/dark current current ratio.

The image sensor 1 as described above has heat and humid resistance which is not deteriorated even after annealing in air at 250°C for 1 hour under 1 atmospheric pressure, or even after auto-clave test at 120°C for 30 minutes under 2 atmospheric pressure.

However, with no covering film being provided there has arisen problems, such as deterioration of the image sensor due to the stain of the transparent upper electrodes and damage by the mechanical contact with other parts likely to occur in the case where the image sensor 1 is used in a picture information processor such as facsimile equipment or the like.

Furthermore, the image sensor 1 may decrease in its insulation properties when moisture in surrounding air is condensed into water on the image sensor. Then it is required that the image sensor is covered with passivation film.

Meanwhile, as one of passivation films used for covering the surface of a photoelectric conversion device silicon oxide film is employed. As a process for forming said silicon oxide film, there are plasma CVD (Chemical Vapor Deposition) method, atmospheric pressure CVD method, sputtering process, spin coating method, etc. Of these methods, plasma CVD method is most desirable in which low temperature process treatment of 400°C or less can be effected at the time of forming the passivation film, because there occurs evolution of hydrogen which has been bonded with silicon atom when the hydrogenated amorphous silicon film is heated at a temperature of 400°C or more.

The plasma CVD method comprises steps of placing a substrate on which a thin film is to be formed in a reaction chamber, introducing a reactive gas for forming the film and, if required, a carrier gas for suitably circulating the reactive gas into the reaction chamber, establishing glow discharge by means of an appropriate dc or ac voltage to dissociate and partly ionize the reactive gas and depositing the reactive gas thus dissociated and partly ionized is on the substrate as the thin film.

In the plasma CVD method, however, since most of the reactive gases require smaller dissociation energy than ionization energy, ionization rate is slower than generation rate of active seeds (radicals) causing reaction and positive ion recombines with electron, whereby many neutral radicals such as hydrogen radicals are caused to be generated in plasma. In other words, active seeds have longer life than ions, and therefore hydrogen radical contained in silane gas reacts with ITO at the early stage of growth of the silicon oxide film in the film formation according to plasma CVD method. As a result, the transparent upper electrode (ITO film) changes in quality, so that junction between the transparent electrode and the hydrogenated amorphous silicon deteriorates. Accordingly, significant decrease in light/dark current ratio will take place due to the increase in dark current.

Summary of the invention

In order to eliminate the disadvantages of the prior art as mentioned above, it is an object of the present invention to provide a process for producing a photoelectric conversion device on the surface of which a passivation film made of silicon oxide, is formed to prevent deterioration in performance of the photoelectric conversion, and at the same time to maintain favorable insulating properties. It is an another object of the present invention to provide a photoelectric conversion device made by the above process.

Accordingly, in the present invention a reactive gas containing a large amount of oxygen is mixed with a small amount of silane gas, and a silicon oxide film is formed on the surface of a photoelectric conversion device in the resulting mixed gas atmosphere in accordance with plasma CVD method. With this construction, the reaction of hydrogen radical contained in silane gas with ITO can be prevented at an early stage of growth of silicon oxide film, thus keeping the junction in good conditions. Thus, it becomes possible to form a passivation film composed of silicon oxide without accompanying deterioration in the properties of the device such as increase of dark current.

The present invention provides a process for producing a photoelectric conversion device having a junction between hydrogenated amorphous silicon and an electrode made of ITO or the like, on the surface of which a passivation film made of silicon oxide is provided, wherein said passivation film made of silicon oxide is formed in accordance with plasma CVD method in an atmosphere of mixed gas prepared by admixing an excess of a gas containing oxygen such as nitrous oxide gas, carbon dioxide gas, oxygen gas or the like with silane gas.

The present invention also provides a photoelectric conversion device having junction between hydrogenated amorphous silicon and ITO, the surface of said photoelectric conversion device being covered with a silicon oxide film formed in accordance with plasma CVD method in an atmosphere of mixed gas consisting of silane gas and an excessive gas containing oxygen.

Brief description of the drawings

In the accompanying drawings:

Fig. 1 is a cross-sectional view showing a conventional image sensor;

Fig. 2 is a cross-sectional view showing an image sensor produced by the process according to the present invention; and

Fig. 3 is a schematic perspective view illustrating a formation of passivation film which is a step in the process according to the present invention.

Description of the preferred embodiment

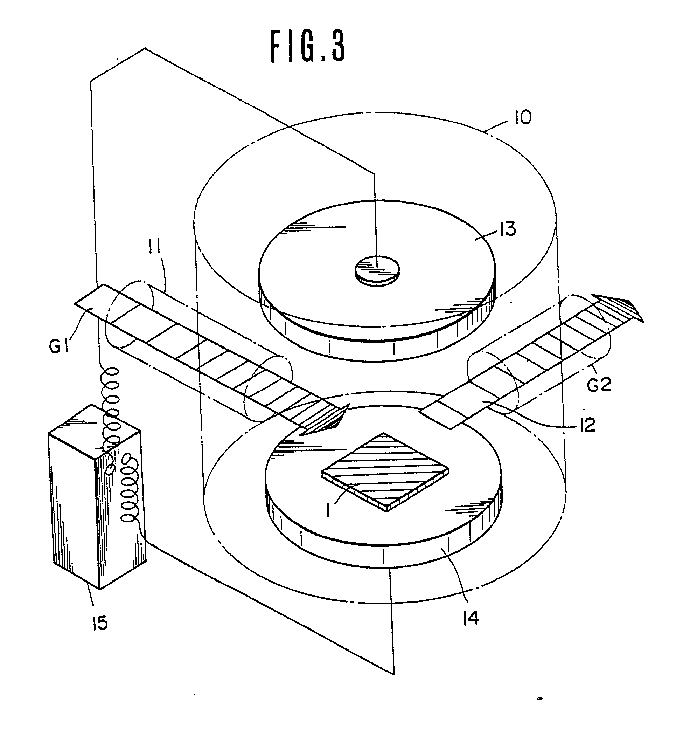

Fig. 2 is a cross-sectional view showing an image sensor produced by the process in accordance with the present invention wherein the same reference numerals in Fig. 1 are used for parts which function similarly to that of Fig. 1.

As shown in Fig. 2, an image sensor 1 has a construction obtained by forming a lower electrode 3 on a glass substrate 2, depositing a hydrogenated amorphous silicon film 4 onto the glass substrate so as to cover a part of the lower electrode 3, depositing a transparent upper electrode 5 to the substrate so as to partly cover the hydrogenated amorphous silicon film 4, and further covering the whole surface other than portions of the substrate 2 corresponding to terminals (not shown) for the transparent upper and the lower electrodes 5 and 3 with a silicon oxide film 6.

Now, a process for producing image sensor 1 of the present invention will be detailed.

First, chromium is deposited on the whole surface of the glass substrate 2 with a thickness of 300 nm (3000 Å) and photoetching it to form the lower electrode 3 having a suitable shape and size. The amorphous silicon film 4 is formed in such a manner that silane gas is dissociated by means of glow discharge to deposit hydrogenated amorphous silicon with a thickness of about 1 μm. Then, the transparent upper electrode 5 is prepared by depositing an ITO film with a thickness of about 150 nm (1500 Å) under argon and oxygen atmosphere in accordance with dc sputtering. Furthermore, portions of the external connecting terminals (not shown) for the lower electrode 3 and the transparent upper electrode 5 are covered with a metal mask.

The silicon oxide film 6 is formed on the top surface of the image sensor 1 thus obtained in accordance with plasma CVD method.

Referring to Fig. 3, the image sensor 1 is placed on an electrode plate 14 in a reaction chamber 10. Distance between the electrode plate 14 and an electrode plate 13 being opposed thereto is 40 mm, and radio frequency potential of 13.6 MHz, 100 to 200 W is applied from a power source 15 to the gap between both the electrode plates 13 and 14. In this case, temperature of the substrate 2 is 200 to 300°C, and pressure in the reaction chamber 10 is 0.5 to 1.5 Torr. The reaction chamber 10 is arranged such that a mixed gas consisting of silane ($SiH_4$) gas and nitrous oxide ($N_2O$) gas flows through an intake port 11 thereinto as indicated by an arrow G1 as a reactive gas required for forming the silicon oxide film 6, whereas the waste gas flows out through an exhaust port 12 as indicated by an arrow G2. In general, the intake port 11 is incorporated in the electrode plate 13, and the reactive gas flows through a number of intake holes bored on the electrode plate 13 into the reaction chamber 10.

In the present embodiment, a ratio of flow of nitrous oxide gas to silane gas is adjusted to be within a range of 20:1 to 80:1. That is, nitrous oxide gas is excessively used as compared with silane gas. Because of the excessive nitrous oxide gas, hydrogen contained in silane gas is allowed to combine with oxygen contained in nitrous oxide gas to produce water, thus preventing the change in properties of the ITO film by extra hydrogen radical. Nitrogen contained in nitrous oxide gas is incorporated into the passivation film 6 in a proportion of 0 to 10 atom percent, which will not raise a problem because nitrogen contributes to improvement in humid resistance of the passivation film 6.

It is to be noted that inert gas such as argon (Ar), helium (He) or the like gas may be further added as a carrier gas to an admixed gas of silane gas, nitrous oxide gas and ammonia employed in the present embodiment.

The silicon oxide film 6 is formed under such conditions of temperature, pressure, voltage and mixed gas as described above. The sensor 1 covered with the silicon oxide film 6 thus formed is subjected to Pressure Cook test for 30 minutes under conditions of 120°C and 2 atm. In the following Table 1, the light/dark current ratio of the sensor 1 before and after covering the same with the silicon oxide film 6 as well as after the above Pressure Cook test will be shown.

TABLE 1

| | Light current | Dark current | Light/Dark current ratio |
|---|---|---|---|
| Before Covering Sensor With Silicon Oxide Film 6 | $9.0\times10^{-10}$A | $1.8\times10^{-13}$A | 5000 |
| After Covering Sensor With Silicon Oxide Film 6 | $8.5\times10^{-10}$A | $2.8\times10^{-13}$A | 3000 |
| After Pressure Cook Test | $8.5\times10^{-10}$A | $2.9\times10^{-13}$A | 3000 |

In Table 1, light current is a value obtained by subtracting dark current from the current flowing through the image sensor 1 when bias voltage of −5 V is applied to the transparent upper electrode 5 of the sensor 1 and light of 100 lx emitted from a green fluorescent lamp is used during measurement of photocurrent, and light/dark current ratio is a value obtained by dividing the light current value by dark current value. As is apparent from Table 1, photocurrent decreased by around 6% after covering the image sensor 1 with the silicon oxide film 6, whilst dark current increased so that light/dark current ratio decreased. Such decrease of the photocurrent may be considered to be due to the reflection of light at the surface of the silicon oxide film 6 as well as at the interfacial boundary between the silicon oxide film 6 and the transparent upper electrode 5. However, such problem can be improved by optimalizing a film thickness of the silicon oxide film 6. Furthermore, light/dark current ratio 3000 is sufficient for practical use. Besides, there is no decrease in light/dark current ratio of the image sensor after applying the Pressure Cook test.

It is to be understood that the present invention is not only applied to production of the image sensor, but also production of a photoelectric conversion device employed in solar cell and the like, and particularly the invention is effective for a device wherein a transparent electrode of an ITO film is used on the surface by which light is received.

**Claims**

1. A process for forming a passivation film on the surface of a photoelectric conversion device having a junction between hydrogenated amorphous silicon and a transparent conductive electrode, characterized in that said process comprises a step of depositing silicon oxide on said photoelectric conversion device as the passivation film in an atmosphere of mixed gas prepared by admixing a silane gas with an excess of an oxygen-containing gas in accordance with the plasma CVD method.

2. A process for forming a passivation film as claimed in claim 1, characterized in that said oxygen-containing gas is a gas selected from the group consisting of nitrous oxide gas, carbon dioxide gas and oxygen gas.

3. A process for forming a passivation film as claimed in claim 1, characterized in that said oxygen-containing gas is admixed with said silane gas in a mixing ratio of 20:1 to 80:1.

4. A process for forming a passivation film as claimed in claim 1, characterized in that said transparent conductive electrode is made of indium-tin oxide.

5. A process for forming a passivation film as claimed in claim 1, characterized in that said mixed gas contains an inert gas such as argon, helium or the like as a carrier gas.

6. A photoelectric conversion device having a junction between hydrogenated amorphous silicon and indium-tin oxide, characterized in that said device has a passivation film made of a silicon oxide film covering the surface of said photoelectric conversion device, said silicon oxide film being obtainable in an atmosphere of mixed gas consisting of silane gas and a gas containing an excess of oxygen in accordance with the plasma CVD method.

**Patentansprüche**

1. Verfahren zur Bildung eines Passivierungsfilms auf der Oberfläche einer photoelektrischen Umwandlungsvorrichtung mit einer Verbindung zwischen hydriertem amorphen Silicium und einer transparenten leitfähigen Elektrode, dadurch gekennzeichnet, daß das Verfahren einen Schritt umfaßt, bei dem Siliciumoxid als Passivierungsfilm auf der photoelektrischen Umwandlungsvorrichtung in einer Atmosphäre eines Gasgemischs, das durch Vermischen eines Silan-Gases mit einem Überschuß eines sauerstoffhaltigen Gases hergestellt wurde, nach dem Plasma-CVD-Verfahren abgelagert wird.

2. Verfahren zur Bildung eines Passivierungsfilms nach Anspruch 1, dadurch gekennzeichnet, daß das sauerstoffhaltige Gas ein aus der aus Lachgas (Distickstoffoxid-Gas), Kohlenstoffdioxid-Gas und Sauerstoff-Gas bestehenden Gruppe ausgewähltes Gas ist.

3. Verfahren zur Bildung eines Passivierungsfilms nach Anspruch 1, dadurch gekennzeichnet, daß das sauerstoffhaltige Gas mit dem Silan-Gas in einem Mischungsverhältnis von 20:1 bis 80:1 vermischt wird.

4. Verfahren zur Bildung eines Passivierungsfilms nach Anspruch 1, dadurch gekennzeichnet, daß die transparente leitfähige Elektrode aus Indiumzinnoxid hergestellt ist.

5. Verfahren zur Bildung eines Passivierungsfilms nach Anspruch 1, dadurch gekennzeichnet, daß das Gasgemisch ein inertes Gas wie Argon, Helium oder dergleichen als Trägergas enthält.

6. Photoelektrische Umwandlungsvorrichtung mit einer Verbindung zwischen hydriertem amorphen Silicium und Indiumzinnoxid, dadurch gekennzeichnet, daß die Vorrichtung einen Passivierungsfilm aus einem Siliciumoxidfilm aufweist, der die Oberfläche der photoelektrischen Umwandlungsvorrichtung bedeckt, wobei dieser Siliciumoxidfilm in einer Atmosphäre eines Gasgemischs, das aus Silan-Gas und einem einen Überschuß an Sauerstoff enthaltenden Gas besteht, nach dem Plasma-CVD-Verfahren erhältlich ist.

**Revendications**

1. Un procédé pour former un film de passivation sur la surface d'un dispositif de conversion photoélectrique ayant une jonction entre du silicium amorphe hydrogéné et une électrode conductrice transparente, caractérisé en ce que ledit procédé comprend une étape de dépôt d'oxyde de silicium sur ledit dispositif de conversion photoélectrique en tant que film de passivation dans une atmosphère d'un gaz mixte préparé en mélangeant un gaz silane avec un excès d'un gaz contenant de l'oxygène selon la méthode au plasma CVD.

2. Un procédé pour former un film de passivation selon la revendication 1, caractérisé en ce que ledit gaz contenant de l'oxygène est un gaz choisi parmi le groupe comprenant l'oxyde d'azote gazeux, le dioxyde de carbone gazeux et l'oxygène gazeux.

3. Un procédé pour former un film de passivation selon la revendication 1, caractérisé en ce que ledit gas contenant de l'oxygène est mélangé avec ledit gaz silane dans un rapport de mélange de 20:1 à 80:1.

4. Un procédé pour former un film de passivation selon la revendication 1, caractérisé en ce que ladite électrode conductrice transparente est constituée d'oxyde d'indium-étain.

5. Un procédé pour former un film de passivation selon la revendication 1, caractérisé en ce que ledit gaz mixte contient un gaz inerte tel que de l'argon, de l'hélium ou analogue en tant que gaz de support.

6. Un dispositif de conversion photoélectrique ayant une jonction entre du silicium amorphe hydrogéné et de l'oxyde d'indium-étain, caractérisé en ce que ledit dispositif comprend une pellicule de passivation réalisée sous forme d'un film d'oxyde de silicium recouvrant la surface dudit dispositif de conversion photoélectrique, ledit film d'oxyde de silicium pouvant être obtenu dans une atmosphère d'un gaz mixte constitué de silane et d'un gaz contenant un excès d'oxygène selon la méthode au plasma CVD.

FIG.1

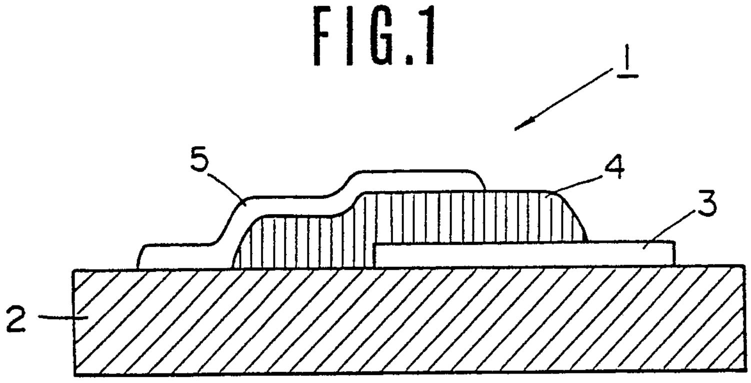


FIG.2

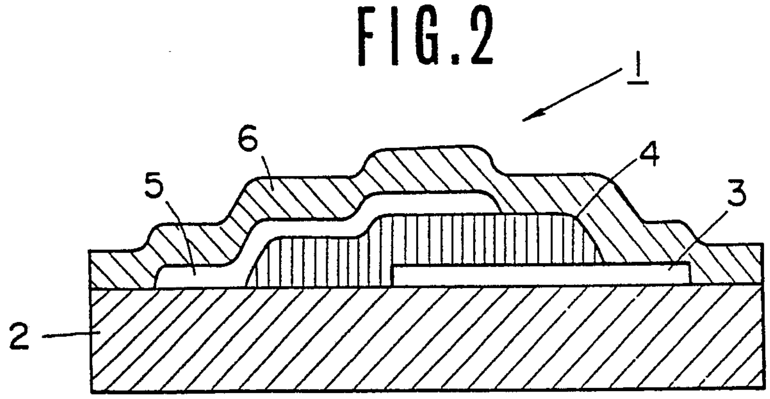

FIG.3